# DEMANDE DE BREVET EUROPEEN

(11) **EP 4 492 159 A1**
(43) Date de publication de la demande: **15.01.2025**
(21) Numéro de dépôt: 23184370.7
(22) Date de dépôt: 10.07.2023
(51) Int. Cl.: G04B 39/02, G04B 39/00, G04B 37/02

(54) **PIÈCE D'HORLOGERIE COMPORTANT UNE GLACE DE PROTECTION AVEC UN DISPOSITIF ANTIBUÉE**

(71) Demandeur: The Swatch Group Research and Development Ltd, 2074 Marin (CH)
(72) Inventeur: MARTIN, Jean-Claude, 2037 Montmollin (CH)
(74) Mandataire: ICB SA

(57) **Abrégé**

L'invention concerne une pièce d'horlogerie (10) comportant une carrure (11) fermée par un fond (12) et par une glace de protection (13), ladite pièce d'horlogerie (10) étant caractérisée en ce qu'elle comporte un dispositif antibuée (100) de ladite glace de protection (13), ledit dispositif antibuée (100) comportant une couche d'oxydes transparents conducteurs (105) ménagée au moins sur une portion d'une surface interne de la glace de protection (13) ; un organe d'interface thermique (106), présentant une conductivité thermique supérieure ou égale à 1 W/m.K, ménagé dans ladite carrure (11) et configuré pour : ) assurer un échange thermique par contact entre ladite couche d'oxyde conducteur (105) et la carrure (11), la carrure (11) et ledit fond (12) étant réalisés dans une matière thermoconductrice, ou b) assurer un échange thermique par contact entre ladite couche d'oxyde conducteur (105) et le fond (12), ledit fond (12) comportant au moins une partie (12a) réalisée dans une matière thermoconductrice en contact avec ledit organe d'interface thermique (106).

## Description

### Domaine technique de l'invention

La présente invention concerne une pièce d'horlogerie comportant une glace de protection présentant un dispositif antibuée pour éviter ou limiter la formation de buée, ou de fines gouttelettes d'eau, à la surface interne de la glace de protection.

### Arrière-plan technologique

Les pièces d'horlogerie sont portées au quotidien dans des environnements très variables en terme d'humidité relative, de pression et de température. Une pièce d'horlogerie empêche structurellement l'humidité de pénétrer dans le corps principal, mais elle subit des échanges gazeux entre l'intérieur du corps principal et l'ambiance extérieure, et ce, malgré une étanchéité à l'eau assurée.

Cet échange gazeux, appelé perméation, se passe au travers des joints qui sont majoritairement en matériaux polymères dont la propriété de perméation est variable, mais jamais nulle. Il arrive donc régulièrement que dans des environnements très chauds et humides, de la vapeur d'eau pénètre dans une pièce d'horlogerie, ce qui en soit n'est pas un problème car invisible pour l'utilisateur tant qu'il n'y a pas de buée visible sur la face interne de la glace de protection.

La buée se forme le plus souvent au moment où la température vue par le porteur s'abaisse, par exemple en se baignant ou en entrant dans un environnement climatisé dans lequel la température est plusieurs degrés plus basse que précédemment. La glace de protection étant le point le plus en contact avec l'environnement extérieur, de fines gouttelettes d'eau formées par condensation adhèrent naturellement sur la surface interne de la glace de protection. Le porteur constate la présence de buée à l'intérieur de la pièce d'horlogerie et pense alors souvent, mais à tort, que son produit n'est plus étanche à l'eau. Ce phénomène est source de nombreux retours de marché, mais aussi de perte de confiance des usagers, et donc de dégradation d'image pour la marque horlogère.

Il existe des traitements hydrophiles consistant en l'application d'un agent tensioactif sur la surface interne de la glace de protection afin d'éviter l'adhérence de fines gouttelettes d'eau sur la surface de la glace de protection. En effet, ces couches hydrophiles permettent à l'eau de s'étaler sur toute la surface interne de la glace de protection et reste donc invisible par le porteur. Cependant, ces couches hydrophiles ne sont pas toujours compatibles avec une esthétique de qualité (coloration, effet diffusant, etc).

Il existe une autre méthode basée sur le principe d'absorption de l'eau contenue dans la vapeur pénétrant dans la pièce d'horlogerie. Toutefois, ces solutions sont limitées dans le temps et les capacités d'absorption sont limitées (en quantité). Par conséquent, ces solutions ne sont pas entièrement satisfaisantes.

Il existe donc un besoin d'amélioration de la capacité antibuée des glaces de protection et des pièces d'horlogerie équipées de telles glaces de protection.

### Résumé de l'invention

A cette fin, la présente invention propose une solution pour répondre aux problématiques de l'état de la technique en proposant une pièce d'horlogerie munie d'une glace de protection comportant un dispositif antibuée transparent, présentant une excellente capacité antibuée permettant d'empêcher la formation de buée dans divers environnements d'utilisation, dont l'efficacité n'est pas limitée dans le temps et qui n'est pas limité par une capacité maximale d'absorption.

Dans ce contexte, l'invention propose une pièce d'horlogerie comportant une carrure dans laquelle un mouvement d'horlogerie est logé, la carrure étant fermée par un fond et par une glace de protection, ladite pièce d'horlogerie étant caractérisée en ce qu'elle comporte un dispositif antibuée de ladite glace de protection, ledit dispositif antibuée comportant :
- une couche d'oxydes transparents conducteurs ménagée au moins sur une portion d'une surface interne de la glace de protection ;
- un organe d'interface thermique, présentant une conductivité thermique supérieure ou égale à 1 W/m.K, ménagé dans ladite carrure et configuré pour :
   a) assurer un échange thermique par contact entre ladite couche d'oxyde conducteur et la carrure, la carrure et ledit fond étant réalisés dans une matière thermoconductrice, ou
   b) assurer un échanger thermique par contact entre ladite couche d'oxyde conducteur et le fond, ledit fond comportant au moins une partie réalisée dans une matière thermoconductrice en contact avec ledit organe d'interface thermique.

Le dispositif antibuée selon l'invention permet de créer un chauffage passif de la glace de protection en utilisation les propriétés de conduction thermique de la couche d'oxydes transparents conducteurs et en mettant en contact celle-ci avec le fond en matière thermoconductrice pour bénéficier de la chaleur corporelle du porteur lorsque la pièce d'horlogerie est portée. Ainsi, la glace de protection n'est plus le point froid de la pièce d'horlogerie.

Un tel dispositif antibuée n'est donc pas limité dans le temps et sa capacité à éviter la formation de buée n'est pas limitée.

Le fond qui est thermoconducteur et en contact avec la peau du porteur permet un échange thermique par conduction « directe » avec l'organe d'interface thermique lorsque celui-ci est en contact avec le fond, ou un échange thermique par conduction « indirecte » avec l'organe d'interface thermique, via la carrure 11 en matière thermoconductrice, lorsque l'organe d'interface thermique est en contact uniquement avec la carrure.

Outre les caractéristiques évoquées dans le paragraphe précédent, la pièce d'horlogerie selon l'invention peut présenter une ou plusieurs caractéristiques complémentaires parmi les suivantes, considérées individuellement ou selon toutes les combinaisons techniquement possibles :
- la couche d'oxydes transparents conducteurs est composée d'oxyde d'indium dopé à l'étain, d'oxyde de zinc dopé à l'aluminium, d'oxyde de zinc, ou encore de dioxyde d'étain dopé au fluor ;
- l'organe conducteur thermique est un joint élastomère thermoconducteur ménagée entre la carrure et la glace de protection ;
- le joint élastomère thermoconducteur est en élastomère à base de silicone ou de fluorosilicone ;
- le joint élastomère thermoconducteur assure l'étanchéité de la carrure au niveau de la glace de protection ;
- l'organe d'interface thermique est un tampon thermoconducteur logé dans un logement de la carrure ;
- le tampon thermoconducteur est composé d'un ou plusieurs polymère(s) et de particules métalliques, céramiques, à base de carbone et/ou de fibres de carbone, ou d'un mélange de ces particules et/ou de ces fibres ;
- le tampon thermoconducteur est composé d'élastomère, préférentiellement du silicone, et de particules en céramique ;
- l'organe d'interface thermique est formé par une pluralité de tampons conducteurs ;
- l'organe d'interface thermique présente une forme annulaire.

Selon une première variante de réalisation de l'invention, l'organe d'interface thermique est un tampon thermoconducteur ménagé dans la carrure, l'organe d'interface thermique étant en contact avec la couche d'oxydes transparents conducteurs et au moins une partie du fond pour assurer un échange thermique par conduction entre la couche d'oxyde conducteur et le fond.

Dans cette première variante de réalisation de l'invention, la pièce d'horlogerie peut comporter en outre un système de positionnement de l'organe d'interface thermique réalisé au moins en partie dans une matière isolante thermiquement et configuré pour assurer une conduction thermique entre le fond et la couche d'oxyde conducteur tout en isolant thermiquement l'organe d'interface thermique de la carrure.

Selon une deuxième variante de réalisation de l'invention, l'organe d'interface thermique est un tampon thermoconducteur ménagé dans la carrure, l'organe d'interface thermique étant en contact avec la couche d'oxydes transparents conducteurs et la carrure pour assurer un échange thermique par conduction entre la couche d'oxyde conducteur et la carrure. La carrure et le fond sont en matière thermoconductrice de sorte qu'un échange thermique par conduction est assuré entre la carrure et le fond.

Dans cette deuxième variante de réalisation, la carrure peut comporter un insert isolant thermiquement permettant d'empêcher un échange thermique par conduction puis convection entre l'environnement extérieure et l'organe d'interface thermique, via la carrure.

### Brève description des figures

Les buts, avantages et caractéristiques de la présente invention apparaîtront à la lecture de la description détaillée ci-dessous faisant référence aux figures suivantes :
- la figure 1 représente schématiquement une vue partielle en coupe d'un premier exemple de réalisation d'une pièce d'horlogerie comportant un dispositif antibuée selon l'invention ;
- la figure 2 représente schématiquement une alternative de réalisation du premier exemple de réalisation illustré à la figure 1 ;
- la figure 3 représente schématiquement une vue partielle en coupe d'un deuxième exemple de réalisation d'une pièce d'horlogerie comportant un dispositif antibuée selon l'invention.

Dans toutes les figures, les éléments communs portent les mêmes numéros de référence sauf précision contraire.

### Description détaillée de l'invention

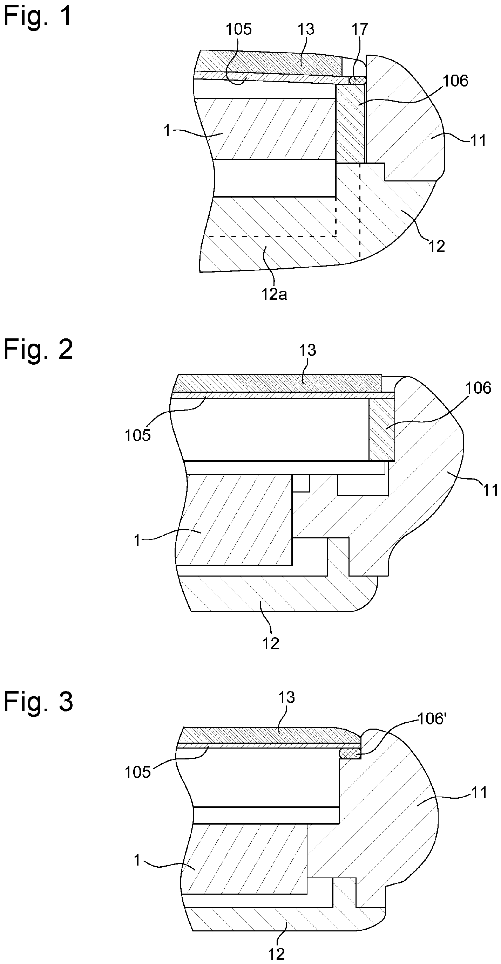

La figure 1 représente schématiquement une vue partielle en coupe d'un premier exemple de réalisation d'une pièce d'horlogerie 10 comportant un dispositif antibuée 100 selon l'invention.

La pièce d'horlogerie 10, telle qu'une montre bracelet, est destinée à être portée au contact de la peau de l'utilisateur, par exemple au poignet.

La pièce d'horlogerie 10 comporte une carrure 11, destinée à recevoir un mouvement d'horlogerie 1.

Le mouvement d'horlogerie 1 peut être un mouvement mécanique, électromécanique ou encore électronique. Préférentiellement, le mouvement d'horlogerie 1 est un mouvement mécanique.

La carrure 11 est fermée en partie inférieure par un fond 12 et en partie supérieure par une glace de protection 13, de manière à protéger le mouvement d'horlogerie 1.

La pièce d'horlogerie 10 comporte également un bracelet (non représenté) souple ou articulé dont deux extrémités sont destinées à être couplées, par exemple de manière amovible, à la carrure 11, via un système de fixation ad hoc qui ne sera pas détaillé dans la présente demande, permettant à l'utilisateur de porter la pièce d'horlogerie 10, par exemple au poignet, et d'avoir la surface extérieure du fond 12 en contact avec la peau du porteur.

Le fond 12 présente au moins une partie 12a réalisée dans une matière thermoconductrice, par exemple à base métallique et/ou céramique et/ou polymère chargé de fibres de carbone. Cette partie 12a est agencée pour être en contact avec la peau du porteur.

Préférentiellement, le fond 12 est réalisée intégralement dans une matière thermoconductrice, préférentiellement dans une matière à base métallique et/ou céramique et/ou polymère chargé de fibres de carbone.

De manière générale, dans la présente demande, on considère une matière thermoconductrice lorsqu'elle présente une conductivité thermique supérieure ou égale à 1 W/m.K (Watt/mètre.Kelvin).

Préférentiellement, le fond 12, ou au moins la partie 12a du fond 12, est réalisé(e) dans une matière thermoconductrice présentant une conductivité thermique supérieure à 10 W/m.K.

La pièce d'horlogerie 10 comporte également un dispositif antibuée 100 de ladite glace de protection 13 permettant d'éviter la formation de buée sur la surface interne de la glace de protection 13, c'est-à-dire la surface en regard avec le mouvement d'horlogerie 1 ou de limiter/réduire la présence de buée visible suite à un choc thermique important.

A cet effet, le dispositif antibuée 100 comporte une couche d'oxydes transparents conducteurs 105 (TCO, pour *Transparent Conductive Oxide en langue anglaise)* ménagée directement au moins sur une portion de la surface interne de la glace de protection 13.

Avantageusement, la couche d'oxydes transparents conducteurs 105 est ménagée sur toute la surface interne de la glace de protection 13.

Si la couche d'oxydes transparents conducteurs 105 est ménagée sur une portion de la surface interne de la glace de protection 13, celle-ci doit être suffisamment étendue pour assurer une mise en température de la glace de protection 13 et éviter la formation de buée.

Cette couche d'oxydes transparents conducteurs 105 présente des propriétés thermiques et de conduction qui sont utilisées dans le dispositif antibuée 100 selon l'invention.

Préférentiellement, la couche d'oxydes transparents conducteurs est déposée sur la glace de protection 13 par une méthode de dépôt chimique en phase vapeur (CVD) ou par une méthode de dépôt physique en phase vapeur (PVD). Toutefois, d'autres méthodes de dépôt de couches minces connues de l'homme du métier sont également possibles.

La couche d'oxydes transparents conducteurs 105 est par exemple composée d'oxyde d'indium dopé à l'étain, d'oxyde de zinc dopé à l'aluminium, d'oxyde de zinc, ou encore de dioxyde d'étain dopé au fluor..

Le dispositif antibuée 100 comporte également un organe d'interface thermique 106 ménagé dans la carrure 11 et configuré pour mettre en contact thermique par conduction la couche d'oxydes transparents conducteurs 105 avec le fond 12, ou au moins avec la partie 12a en matière thermoconductrice du fond 12, si celui-ci n'est pas entièrement réalisé en matière thermoconductrice.

Selon une alternative de réalisation illustrée à la figure 2, l'organe d'interface thermique 106 peut être configuré pour mettre en contact thermique, par conduction, la couche d'oxydes transparents conducteurs 105 avec la carrure 11, si celle-ci est réalisée dans une matière thermoconductrice, la carrure 11 assurant alors un échange thermique avec le fond 12, ou la partie 12a du fond 12, en matière thermoconductrice.

Selon les besoins, l'organe d'interface thermique 106 peut être réalisé dans une matière favorisant les échanges thermiques par conduction tout en étant isolant électriquement.

L'organe d'interface thermique 106 est par exemple un tampon thermoconducteur présentant une conductivité thermique supérieure ou égale à 1 W/m.K, préférentiellement supérieure à 2 W/m.K.

L'organe d'interface thermique 106 est ménagé dans un logement de la carrure 11, par exemple via un système de positionnement.

Un tel système de positionnement peut par exemple comporter un élément isolant thermiquement, ou être totalement dans une matière isolante thermiquement, de manière à privilégier la conduction thermique entre le fond 12 et la couche d'oxydes transparents conducteurs 105, tout en isolant thermiquement l'organe d'interface thermique 106 de la carrure 11 pour éviter des déperditions thermiques par conduction avec la carrure 11 en contact avec l'environnement extérieur.

L'organe d'interface thermique 106 est par exemple un tampon thermoconducteur composé d'un ou de plusieurs polymère(s), par exemple d'élastomère, et de particules métalliques, céramiques, à base de carbone et/ou de fibres de carbone, ou d'un mélange de ces particules et/ou de ces fibres.

L'organe d'interface thermique 106 est par exemple un tampon thermoconducteur composé de silicone et de particules métalliques et/ou céramiques.

L'organe d'interface thermique 106 est par exemple un tampon thermoconducteur de forme annulaire pour être en contact avec la couche d'oxydes transparents conducteurs 105 au niveau d'un pourtour périphérique de la glace de protection 13 et du fond.

L'organe d'interface thermique 106 peut être formé par une pluralité de tampons thermoconducteurs répartis à l'intérieur de la carrure 11, pour créer plusieurs points de conduction thermique entre le fond 12, la partie 12a du fond 12, ou la carrure 11, et la couche d'oxydes transparents conducteurs 105.

Comme illustré à la figure 1, une joint d'étanchéité 17 peut être ménagé entre la glace de protection 13 et la carrure 11 pour assurer une étanchéité à l'eau de la pièce d'horlogerie 10.

Le dispositif antibuée 100 selon l'invention permet de créer un chauffage passif par conduction de la glace de protection 13 en utilisant la chaleur corporelle du porteur lorsque la pièce d'horlogerie 10 est portée.

Le fond 12 qui est thermoconducteur et en contact avec la peau du porteur permet un échange thermique par conduction « directe » avec l'organe d'interface thermique 106 lorsque celui-ci est en contact avec le fond 12, ou un échange thermique par conduction « indirecte » avec l'organe d'interface thermique 106, via la carrure 11 en matière thermoconductrice, lorsque l'organe d'interface thermique 106 est en contact uniquement avec la carrure 11.

L'organe d'interface thermique 106 assure également un échange thermique par conduction avec la couche d'oxydes transparents conducteurs 105 afin d'éliminer le point froid pouvant exister au niveau de la glace de protection 13.

Grâce à l'invention, le point froid n'est plus situé sur la glace de protection 13. Par conséquent, la buée, si elle doit se former, se formera ailleurs dans une zone froide non visible par le porteur, par exemple sous le cadran.

La figure 3 illustre un deuxième exemple de réalisation de l'invention.

Dans ce deuxième exemple de réalisation, l'organe d'interface thermique 106' est un joint élastomère thermoconducteur positionné entre la glace de protection 13 et la carrure 11, qui est obligatoirement en matière thermoconductrice ou composée d'une partie intérieure thermoconductrice dans ce deuxième exemple de réalisation pour pouvoir échanger thermiquement avec le fond 12 ou la partie 12a du fond en matière thermoconductrice.

Dans ce deuxième exemple de réalisation, l'organe d'interface thermique 106' assure également une étanchéité à l'eau entre la glace de protection 13 et la carrure 11.

Le joint élastomère thermoconducteur formant l'organe d'interface thermique 106' est par exemple un élastomère à base de silicone ou de fluorosilicone.

Le joint élastomère thermoconducteur formant l'organe d'interface thermique 106' est par exemple chargé en matière métallique (par exemple aluminium), en carbone (par exemple graphite), en matière céramique ou par un mélange de ces matières.

## Revendications

1. Pièce d'horlogerie (10) comportant une carrure (11) fermée par un fond (12) et par une glace de protection (13), ladite pièce d'horlogerie (10) étant **caractérisée en ce qu'**elle comporte un dispositif antibuée (100) de ladite glace de protection (13), ledit dispositif antibuée (100) comportant :
- une couche d'oxydes transparents conducteurs (105) ménagée au moins sur une portion d'une surface interne de la glace de protection (13) ;
- un organe d'interface thermique (106), présentant une conductivité thermique supérieure ou égale à 1 W/m.K, ménagé dans ladite carrure (11) et configuré pour :
a) assurer un échange thermique par contact entre ladite couche d'oxyde conducteur (105) et la carrure (11), la carrure (11) et ledit fond (12) étant réalisés dans une matière thermoconductrice, ou
b) assurer un échange thermique par contact entre ladite couche d'oxyde conducteur (105) et le fond (12), ledit fond (12) comportant au moins une partie (12a) réalisée dans une matière thermoconductrice en contact avec ledit organe d'interface thermique (106).

2. Pièce d'horlogerie (10) selon la revendication précédente **caractérisée en ce que** la couche d'oxydes transparents conducteurs (105) est composée d'oxyde d'indium dopé à l'étain, d'oxyde de zinc dopé à l'aluminium, d'oxyde de zinc, ou encore de dioxyde d'étain dopé au fluor.

3. Pièce d'horlogerie (10) selon l'une des revendications précédentes **caractérisée en ce que** l'organe conducteur thermique (106) est un joint élastomère thermoconducteur ménagée entre la carrure (11) et la glace de protection (13).

4. Pièce d'horlogerie (10) selon la revendication précédente **caractérisée en ce que** le joint élastomère thermoconducteur est en élastomère à base de silicone ou de fluorosilicone.

5. Pièce d'horlogerie (10) selon la revendication précédente **caractérisée en ce que** le joint élastomère thermoconducteur assure l'étanchéité de la carrure (11) au niveau de la glace de protection (13).

6. Pièce d'horlogerie (10) selon l'une des revendications précédentes **caractérisée en ce que** l'organe d'interface thermique (106) est un tampon thermoconducteur logé dans un logement de la carrure (11).

7. Pièce d'horlogerie (10) selon la revendication précédente **caractérisée en ce que** le tampon thermoconducteur est composé d'une base en polymère et de particules métalliques, céramiques, à base de carbone et/ou de fibres de carbone, ou d'un mélange de ces particules et/ou de ces fibres.

8. Pièce d'horlogerie (10) selon la revendication précédente **caractérisée en ce que** le tampon thermoconducteur est composé d'une base en élastomère, préférentiellement à base de silicone et de particules en céram ique.

9. Pièce d'horlogerie (10) selon l'une des revendications 6 à 8 **caractérisée en ce que** l'organe d'interface thermique (106) est formé par une pluralité de tampons conducteurs.

10. Pièce d'horlogerie (10) selon l'une des revendications 6 à 8 **caractérisée en ce que** l'organe d'interface thermique (106) présente une forme annulaire.

11. Pièce d'horlogerie (10) selon l'une des revendications précédentes **caractérisée en ce qu'**elle comporte un système de positionnement l'organe d'interface thermique (106) configuré pour assurer une conduction thermique entre le fond (12) et la couche d'oxyde conducteur (105) tout en isolant thermiquement l'organe d'interface thermique (106) de la carrure (11).
